# EUROPEAN PATENT APPLICATION

(11) **EP 4 597 571 A1**
(43) Date of publication of application: **06.08.2025**
(21) Application number: 24155144.9
(22) Date of filing: 31.01.2024
(51) Int. Cl.: H01L 23/64, H01L 25/07, H01L 23/498, H02M 7/00

(54) **A MODULE FOR AN ELECTRIC CIRCUIT HAVING A PLANARLY STACKED STRUCTURE FOR POWER PACKAGE TERMINALS, AS WELL AS A RELATED POWER MODULE AND METHOD OF MANUFACTURING SUCH A MODULE**

(71) Applicant: Nexperia B.V., 6534 AB Nijmegen (NL); Nexperia Technology (Shanghai) Ltd., Shanghai 200025 (CN)
(72) Inventor: Gong, Wei, Manchester (GB); Cao, Pulong, Shanghai (CN); Liu, Hui, Shanghai (CN); Wu, Xiangshui, Shanghai (CN); Cui, Song, Shanghai (CN)
(74) Representative: Pjanovic, Ilija

(57) **Abstract**

A module for an electric circuit and method of fabricating said module, wherein the module comprises a substrate comprising electric circuitry, and a Direct Current, DC, power package arranged for providing DC power to the electric circuitry by being electrically connected to the substrate, the DC power package comprises a first DC terminal and a second DC terminal, the second DC terminal being electrically isolated from the first DC terminal, wherein the first DC terminal comprises two planar electrical conductors and wherein the second DC terminal comprises one planar electrical conductor. The two planar electrical conductors of the first DC terminal and the one planar electrical conductor of the second DC terminal are planarly stacked with gaps between them, such that the one planar electrical conductor of the second DC terminal is sandwiched between the two planar electrical conductors of the first DC terminal reducing stray inductance in the module.

## Description

A module for an electric circuit having a planarly stacked structure for power package terminals, as well as a related power module and method of manufacturing such a module.

### Technical field

The present disclosure relates to a modules having a sandwich structure for power package terminals and/or busbars, reducing parasitic stray inductance of the entire commutation loop in power electric circuitry.

### Background

Power electric circuits are taking a prominent role in modern day lives, due to global shifts towards electric vehicles, EV, and renewable energy. In both technology fields wide bandgap, WBG, semiconductors transistors are used due to their high voltage and current handling, fast switching speeds, and reduced power losses.

Stray inductances, the unintended and unwanted production of an inductive effect of a wire or an electric element on another, however, limit the performances and efficiency of these WBG transistors in power electric circuitry.

In EVs power circuits, stray inductance in power modules can significantly reduce the efficiency, range, and overall performance of these vehicles. Whereas in renewable energy converters, stray inductances reduce the maximal energy yield and reliability of the WBG transistors in those energy converting power circuits.

WBG transistors may experience voltage overshoots, a transient increase in voltage beyond intended levels, during switching events, which cause adverse effects, such as:
device stress and degradation, wherein voltages higher than rated are causing premature failure of the device due to breakage of the electric component,
electromagnetic interference, wherein voltage overshoots result in highfrequency electromagnetic waves interfering with nearby electric components,
circuit instability, wherein voltage overshoots result in unintended switching event compromising the overall circuit reliability, and
energy loss, wherein voltage overshoots are utilizing more electrical power than is needed for switching.

Fast switching is desired for WBG transistors, but causes high di/dt, in combination with stray inductance the above-mentioned adverse effects are worsened.

### Summary

It would be advantageous to achieve a module for an electric circuit that is arranged in such a way to reduce any loop inductance. It would further be advantageous to achieve a corresponding power module and a method of manufacturing such a module.

In a first aspect of the present disclosure, there is provided a module for an electric circuit, comprising a substrate comprising electric circuitry. The intended goal of the module is to reduce the stray inductance in the overall circuit.

The module comprises a Direct Current, DC, power package arranged for providing DC power to the electric circuitry by being electrically connected to the substrate.

Here, the DC power package comprises a first DC terminal and a second DC terminal, wherein the second DC terminal is electrically isolated from the first DC terminal. The first DC terminal comprises two planar electrical conductors and the second DC terminal comprises one planar electrical conductor.

The two planar electrical conductors of the first DC terminal and the one planar electrical conductor of the second DC terminal are planarly stacked with gaps between them, such that the one planar electrical conductor of the second DC terminal is sandwiched between the two planar electrical conductors of the first DC terminal.

One DC terminal of the power package for either the supply or the return line being at least largely encapsulated by the other DC terminal of the power package for the other of the supply or the return line, enhances magnetic field cancellation and increases the absolute value of the mutual inductance between them.

The above causes the stray inductance introduced by the power terminals to be reduced, resulting in an overall reduction of the total commutation loop stray inductance.

The module may thus comprise a first DC terminal and a second DC terminal. These DC terminals may be connected to the substrate via terminal connections. These terminal connections are the points where external electrical connections are established with the substrate of the module, thereby linking to the electrical circuity on the substrate. Within the context described, the first and second DC terminal may comprise a Direct Current, DC, supply terminal responsible for delivering the necessary DC power and a DC return terminal responsible for enabling a return pathway for the DC power.

In an example, a planar stack of DC terminals, wherein one DC terminal of the power package for either the supply line or the return line, being at least largely encapsulated by the other DC terminal of the power package for the other return or supply line, respectively, can be used as a power package, when the individual DC terminals can connect to the substrate comprising electric circuitry without creating a short-circuit between the two DC terminals.

Therefore, at least one of the two planar electrical conductors of the first DC terminal of the power package of the module for an electric circuit is provided with at least one recess adjacent to the substrate for allowing the one planar electrical conductor of the second DC terminal to connect to the electric circuitry via the at least one recess.

In this way, the individual DC terminals of the planar stack can be electrically connected to the substrate with individual channels on the substrate's electric circuitry, wherein the electric circuitry all lay in the same plane.

In a further example, the at least one recess of the at least one of the two planar electrical conductors of the first DC terminal of the power package of the module for an electric circuit comprises a plurality of recesses, wherein the plurality of recesses is distributed along a direction perpendicular to the stacking direction. This way multiple connections to the circuitry on the substrate can be made, allowing for less resistance for the current flow through the power package into the electric circuitry.

In yet another example, the one planar electrical conductor of the second DC terminal of the power package of the module for an electric circuit is provided with at least one recess adjacent to the substrate, wherein said two planar electrical conductors of the first DC terminal connect to one another and to the electric circuitry via said at least one recess provided in the one planar electrical conductor of the second DC terminal.

The inventors have found that to reduce any stray capacitance in a power package, the one of the DC terminals may be encapsulated by the other DC terminal. In a planar stack, this may encompass that one of the DC terminals is sandwiched between two other DC terminals, wherein the outer two are kept at the same voltage potential, i.e. the outer two are either both the DC supply line or are both the DC return line.

This voltage potential is easiest maintained by electrical connection between the two outer layers of the stacked DC terminals. Here, the preferred design is to connect the outer two layers of the stacked DC terminals at the circuitry of the substrate, which is best achieved when a single electric conducting strip in the electric circuitry is passed underneath the power package, at the top side of the substrate, and thanks to at least one recess adjacent to the substrate in DC terminal in the middle of the stack, which electrically isolates the middle terminal.

These electric conducting strips are part of the electric circuitry on the top side of the substate and run along the stacking direction of the DC terminal. These electric conducting strips may be formed by PCB etching or the like. They form strips or alternating DC supply line and DC return line and are electrically isolated from each other.

To further improve the flow of current and reduce the resistance of the design laid out before, the at least one recess of the one planar electrical conductor of the second DC terminal of the power package comprises a plurality of recesses, wherein said plurality of recesses are distributed along a direction perpendicular to the stacking direction.

In a further example, said plurality of the recesses of the one planar electrical conductor of the second DC terminal is interleaved with said plurality of recesses of the at least one of the two planar electrical conductors of the first DC terminal. This way, the outer two layers of the stacked DC terminals are electrically connected at the circuitry of the substrate through electric conductive strips that run under the planar stack of DC terminals, at the top side of the substrate.

At the same time, these conductive strips offer a connection of the first DC terminal to the electric circuitry on the substrate. Due to the at least one recess in the second DC terminal being located at the conductive strip, the two DC terminals are electrically isolated from each other. In a same manner, different electric conductive strips on the substrate's circuitry are passed underneath the power package, on the top layer of the substrate, and connect electronically to the first DC terminal.

Thanks to said recesses in the second DC terminal, the different electrical conductive strips connect to first DC only, leaving the two DC terminals isolated while still allowing electric connection to the substrate's circuitry.

To aid the connection to the substrate's circuitry and to enlarge the conductive surface between the substrate and the first DC terminal, at least one of the two planar electrical conductors of the first DC terminal is provided with at least one protrusion in a direction along the substrate, wherein said at least one of the two planar electrical conductors of the first DC terminal connects to the electric circuitry via said at least one protrusion.

The at least one protrusion is positioned, in the case of the presence of recesses, on the remaining part adject to the substrate of the DC terminal, such that a foot-like structure is formed, which can be connected to the substrate via laser welding, screw connection, ultrasonic welding, conductive adhesive, or other connection methods. This allows for a robust connection of the DC terminals to the substrate.

In a similar manner, the second DC terminal may be provided with at least one protrusion in a direction along the substrate, wherein said one planar electrical conductor of the second DC terminal connects to the electric circuitry via said at least one protrusion, to enlarge the conductive surface between the substrate and said DC terminal.

Preferably, a footlike structure is formed, in case of the presence of recesses, on the remaining parts of the second DC terminal. In one example, these footlike structures may be facing in the same direction as the footlike structures of the first DC terminal, but they could also face in opposite directions.

In yet another example the power package may be provided with two side electrical conductors electrically connected to both planar electrical conductors of the first DC terminal, said side electrical conductors covering opposite sides of the one planar conductor of the second DC terminal, wherein said sides of the one planar conductor are perpendicular to the stacking direction.

This design encapsulates the sides of the planarly stacked DC terminals, such that the second DC terminal is covered from all sides, except in the direction of current flow, with conductive material. The inventors have found this design to improve encapsulation of the inner DC terminal and found that greater reduction of the stray inductance can be achieved.

In yet another example, all edges of the planar electrical conductors and all edges of said side electrical conductors of the module are rounded. These edges may be rounded to such an extent that a concentric configuration is formed, wherein the first DC terminal has a spherical cross-section and is encapsulated by the second DC terminal also having a spherical cross-section with a larger diameter than the first DC terminal.

In the examples described before, a short-circuit is prevented between the first DC terminal and the second DC terminal. Especially, arcing or electron transfer between the two DC terminals is avoided. An electric isolation can be achieved through gap generation in between the planarly stacked DC terminals. However, here the material in the gaps is also of importance, and preferably but not limited to comprise air, epoxy, resin, Mylar, Kapton, Nomex, or plastics such as ABS, PA, PC or PMMA.

In the examples described before, the gap distance between the planarly stacked DC terminals may also define the efficacy of the electric isolation. The maximum gap distance between any of the planar conductors of the first and the second DC terminal, respectively, is at most 1.5mm.

In yet another example, the first DC terminal comprises three planar electrical conductors, and the second DC terminal comprises two planar electrical conductors. The three planar electrical conductors of the first DC terminal and the two planar electrical conductors of the second DC terminal are planarly stacked, such that a planar stack of alternating planar electrical conductors of the first and the second DC terminal, respectively, is provided. Alternatively, both DC terminals comprise more planar electrical conductors to produce an alternating stack of planar electrical conductors of the first and the second terminal, respectively. This alternating stack helps the reduction of stray inductance due to direct shielding of the opposite terminal on either side of the terminal in a continuous fashion.

In a second aspect of the present disclosure, there is provided a power module comprising a module in accordance with any of the example provided above.

In a third aspect of the present disclosure, there is provided a method of fabricating a module as described in any of the examples before, wherein said method comprises the steps of:
- providing said substrate
- mounting said DC power package to said substrate, such that said DC power package is electrically connected to the substrate. This electrical connection can be achieved through welding, laser welding, ultrasonic welding, screw connection or other connection methods.

In an example, said DC power package is an integral part, wherein said step of mounting comprises:
- mounting said DC power package to said substrate as an integral part. This way, the complete power package can be prefabricated as one single electrical component, which simplifies mounting of the DC power package to the substrate's circuitry.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Fig. 1 Sideview of a module, wherein the planarly stacked DC power package is perpendicular to the substate.
Fig. 2 Sideview of a module, wherein the planarly stacked DC power package is parallel to the substrate with an offset.
Fig. 3 Sideview of a module, wherein there are only two electrical conductors attached to the substrate, but the planarly stack of the DC terminals is achieved through coverage with side conductors.
Fig. 4 3D view of a module, wherein the DC power package comprises recesses and protrusions in an interleaved fashion to form footlike structures for easier attachment to the substrate.
Fig 5. 3D view of a module, wherein the DC power package is wider at the attachment to the substrate and narrower at the other end.
Fig 6. 3D view of a module, wherein the DC power package is provided with recesses and protrusions at the other connection end of the DC terminal.
Fig 7a. An electromagnetic simulation of the state-of-the-art DC power package consisting of only 2 electrical conductors.
Fig 7b. An electromagnetic simulation of the current invention consisting of 3 electrical conductors, wherein the outer most conductors have the same voltage potential sandwiching the inner conductor, thereby reducing stray inductance.
Fig 7c.A graph of the resulting stray inductance of electromagnetic simulations as a function of frequency of the design in 7a is compared against design of 7b.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

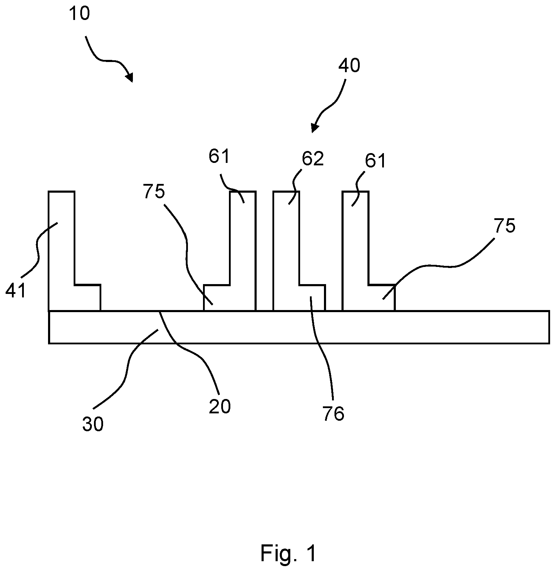

Figure 1 discloses a module for power electric circuits, which reduces the stray inductance in the overall circuit. The module comprising a substrate 30 comprising electric circuitry 20, also comprises a Direct Current, DC, power package 40 arranged for providing DC power to the electric circuitry by being electrically connected to the substrate.

Additionally, Alternating Current, AC, is supplied to the substrate's circuitry 20 through the AC terminal 41. Here, the DC power package comprises a first DC terminal 51 and a second DC terminal 52, wherein the second DC terminal 52 is electrically isolated from the first DC terminal 51. The first DC terminal comprises two planar electrical conductors 61 and the second DC terminal comprises one planar electrical conductor 62. The two planar electrical conductors of the first DC terminal 61 and the one planar electrical conductor of the second DC terminal 62 are planarly stacked with gaps between them, such that the one planar electrical conductor of the second DC terminal 62 is sandwiched between the two planar electrical conductors of the first DC terminal 61. The AC power package comprises only one single electrical conductor connected to the substrate's circuitry.

One DC terminal of the power package for either the supply line or the return line, being at least largely encapsulated by the other DC terminal of the power package for the other of the supply and return line, respectively, enhances magnetic field cancellation and increases the absolute value of the mutual inductance between them. Thereby, the stray inductance introduced by power terminals is reduced, resulting in an overall reduction of the total commutation loop stray inductance and a reduction of the risk for voltage overshooting when switching the WGB semiconductor transistor.

Moreover, in figure 1, the DC power package is oriented perpendicular to the substrate and has gaps between the planarly stacked DC terminals to ensure electrical isolation between the electrical conductors. In this example the two electrical conductors of the first DC terminal are electrically connected through the circuitry on the substrate.

Additionally, in figure 1, the electrical conductors of the DC power package are provided with protrusions to ensure a larger conductive surface between the substrate and the conductor. This reduces the resistance and allows for better current flow, next to facilitating easier attachment of the DC power package to the substrate through for instance welding, laser welding, ultrasonic welding, the use of conductive adhesive, screwing or other connection methods.

In the design of figure 1 the gaps in between electrical conductors of the planarly stacked DC terminals are large enough to accommodate the protrusions along the substrate without causing a short-circuit between them. Additionally, these gaps ensure that no arcing or electron transfer will occur between the electrical conductors along the stack away from the substrate.

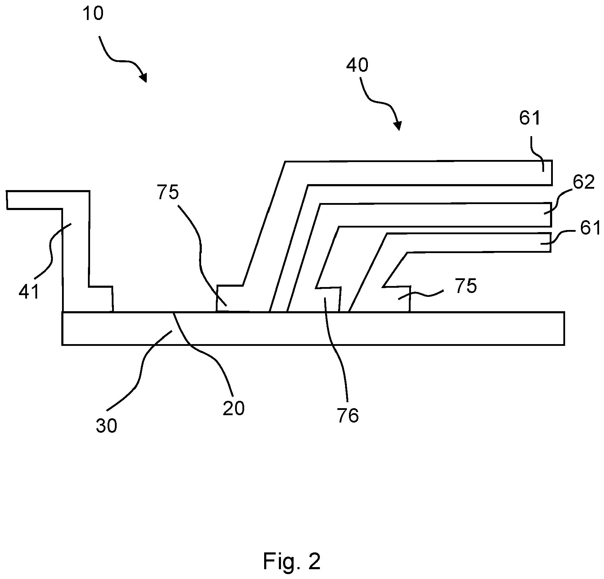

Figure 2 discloses a module as described above, wherein the stacking direction of the DC power terminal is not constant along the stack when seen away from the substrate. In other words, the overall DC terminal geometry is arbitrary, but the internal stack is maintained. As exemplified in figure 2, the DC terminal is formed parallel to the substrate, but with an offset, while still being connected to it. This way the overall size of the module can be kept relatively small.

Moreover, figure 2 discloses a sharp corner in the DC terminal, but is should be clear to the person skilled in the art, that this bend can also be made smooth or such that the final angle of the DC terminal is no longer parallel to the substrate.

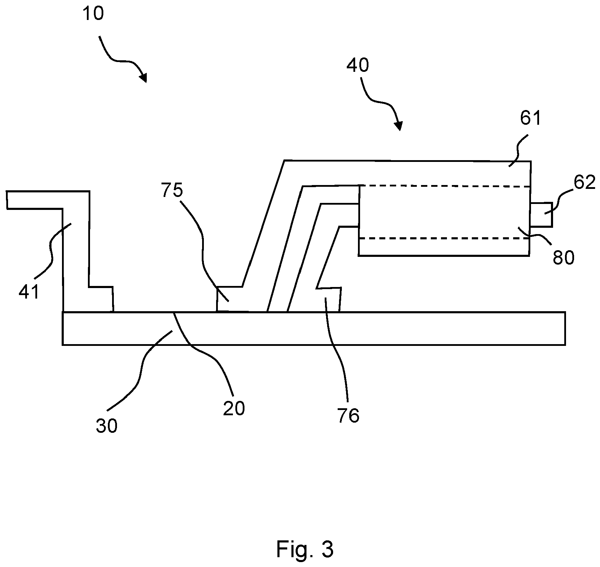

Figure 3 discloses a module as described before, wherein only 2 electrical conductors of the DC terminals are connected to the substrate's circuitry. The sandwiching effect, however, is generated further away from the substrate by inclusion of two side conductors. These side conductors cover the side of the planarly stacked DC terminals and hold one of the planar conductors in place. This design ensures that all the voltage potential of the first DC terminal is maintained along the DC terminal due to the electrical connection along said terminal. Additionally, it offers the best encapsulation of the part of the DC terminal, most susceptible to stray inductance.

Moreover, the edges of the DC terminal, laid out in figure 3, along the current flow can be rounded. This rounding can be done to such an extent that the second, inner, DC terminal obtains a spherical cross-section. In that case, the first DC terminal can be rounded to also obtain a spherical cross-section, such that a concentric configuration is formed of both DC terminals. This way, the best encapsulation is ensured.

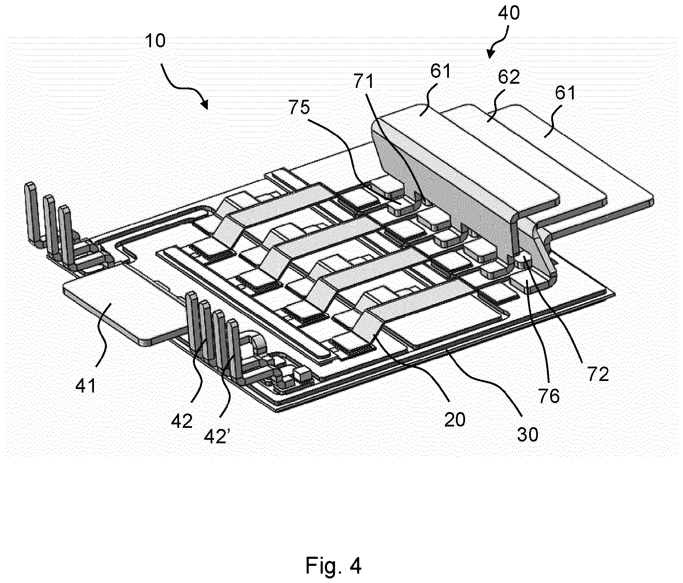

Figure 4 discloses a module as described before comprising a substrate comprising circuitry, an AC terminal, two DC terminals stacked planarly in a sandwich structure, wherein both DC terminals are provided with at least one recess and at least one protrusion forming footlike structures to connect to the substrate with. In figure 4, the aforementioned interleaving of the footlike structures of the electric conductors of the first and second DC terminal, respectively, is implemented.

Additionally, the planarly stacked sandwich structure of electrical conductors of the DC terminal show a parallel orientation to the substrate with an offset seen away from the footlike structures to reduce the overall size of the module.

The inventors have found that this configuration enhances magnetic field cancellation and increases the absolute value of the mutual inductance between them. Thereby, the stray inductance introduced by the DC power terminal is reduced, resulting in an overall reduction of the total commutation loop stray inductance and a reduction of the risk for voltage overshooting when switching the WGB semiconductor transistor.

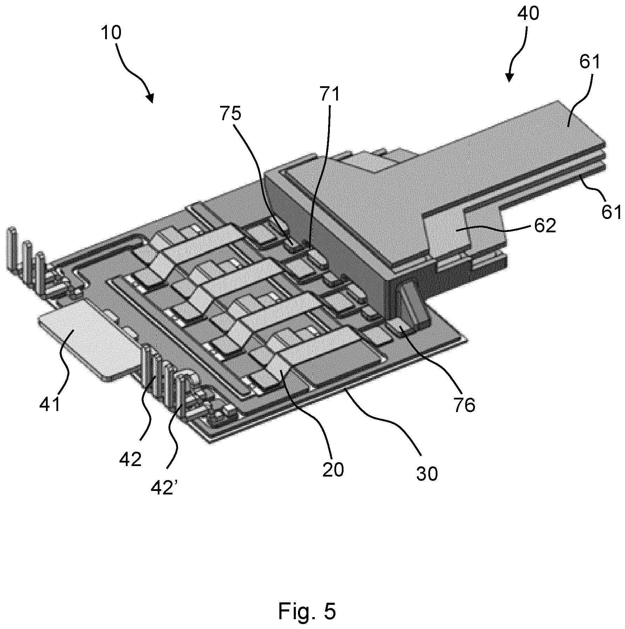

Figure 5 discloses an example of a module, wherein the stack of electric conductors of the DC terminal becomes narrower as seen away from the substrate. Additionally, a plastic holder is shown which holds the first and second DC terminal in place, maintaining gaps between the planar electric conductors, such that electrical isolation is retained. This plastic holder also ensure that the DC terminal can be connected to the substrate as an integral part, since the DC terminal can be manufactured separately. The phrase 'integral part' means that the different parts of the DC terminal may be combined to form one integrated component. Hereafter, the entire DC terminal can be connected to the substrate's circuitry through welding, laser welding, ultrasonic welding, screwing, using conductive adhesive or other connection methods.

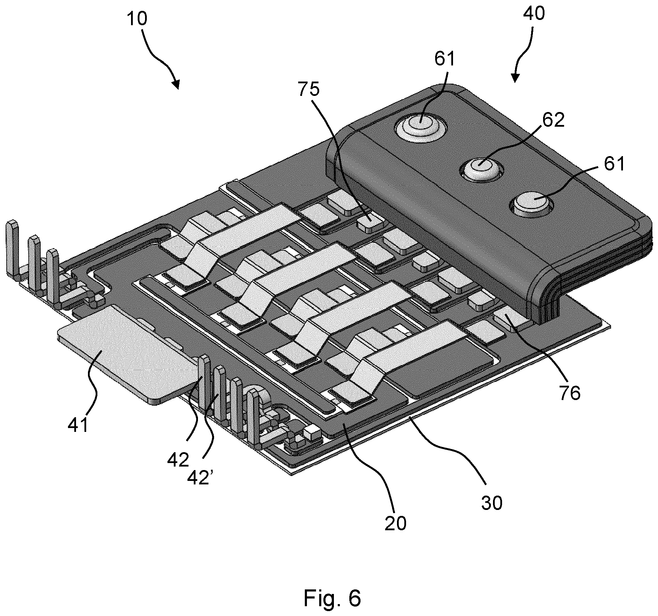

Figure 6 discloses another example of a module, wherein the stack of electric conductors is formed as an integral part. The gaps in between the planarly stacked electrical conductors are filled with a material chosen from the list not limited to air, epoxy, resin, Mylar, Kapton, Nomex, or plastics such as ABS, PA, PC or PMMA. Additionally, the planar stack is provided with recesses extending from the outermost layer of the stack towards the desired electric conductor, whereafter said electric conductor is provided with a protrusion extending out through the recess. In this manner the DC terminal can be manufactured in a laminating process, where electrical conductors are sandwiched between electrical isolating material. Thereafter, the DC connected can be bend and molded into the desired shape, whereafter openings are formed in the outermost layer towards the desired electrical conductor, then provided with a connecting protrusion. This embodiment reduces the overall size of the module, while still allowing easy connection to the individual electric conductors of the DC terminal.

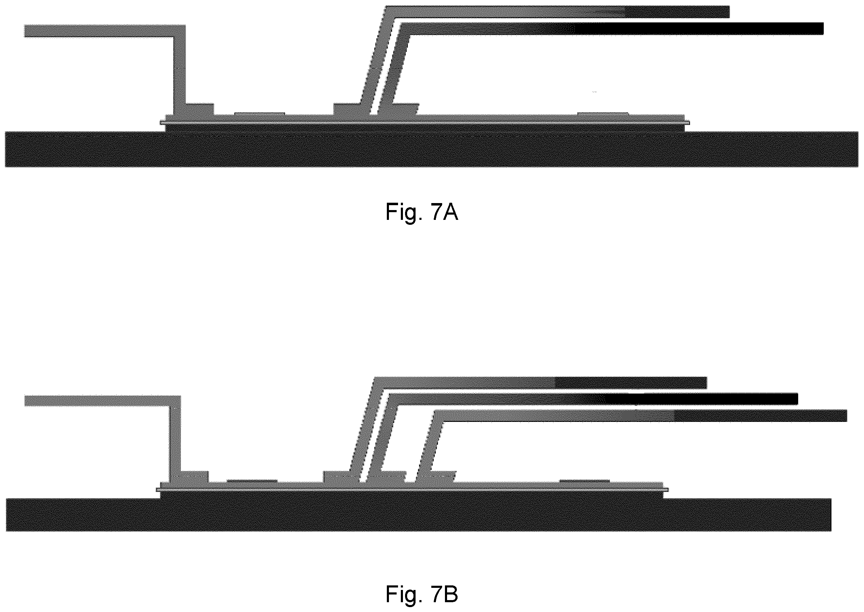

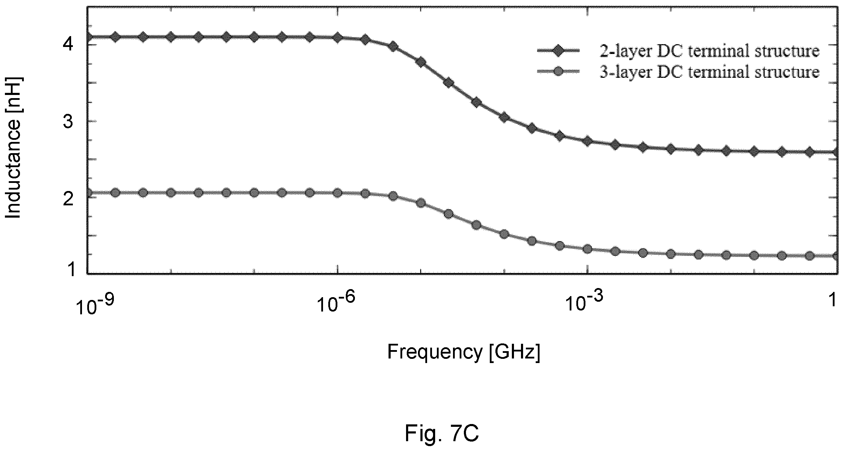

Figure 7 discloses electromagnetic simulations of stray inductance in DC terminal for power electronics based, having a design based on prior art (a) and having a design based on the present disclosure (b). These simulations were performed using Q3D Extractor and the grayscale is indicative of the magnitude of the local voltage potential at the electric conductor. Here, a darker color means a higher magnitude of the voltage potential. Frequency depended stray inductance simulations (c) of the systems in (a) and (b) are simulated. Here, at high frequencies 2.59nH stray inductance is induced in the 2-layer structure, whereas only 1.23nH is induced in the 3-layer sandwich structure. Thereby the present invention is capable of reducing the stray inductance by a little over 50%.

Other variations to the disclosed embodiments can be understood and effected by those skilled in the art in practicing the claimed invention, from a study of the drawings, the disclosure, and the appended claims. The provided figures and descriptions of the embodiments of the invention are illustrative and explanatory to the heart of the invention and should not be seen as limiting the invention thereto. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

### REFERENCE LIST

10 module
20 electric circuit
30 substrate
40 Direct Current, DC, power package
41 Alternating Current, AC, power package
42 control pin
51 first DC terminal
52 second DC terminal
61 planar electrical conductor of the first DC terminal
62 planar electrical conductor of the second DC terminal
71 at least one recess of the at least one of the two planar electrical conductors of the first DC terminal of the power package
72 at least one recess of the one planar electrical conductor of the second DC terminal of the power package
75 at least one protrusion of the at least one of the two planar electrical conductors of the first DC terminal
76 at least one protrusion of the one planar electrical conductor of the second DC terminal
80 electrical side conductors

## Claims

1. A module for an electric circuit, comprising:
- a substrate comprising electric circuitry;
- a Direct Current, DC, power package arranged for providing DC power to the electric circuitry by being electrically connected to the substrate, the DC power package comprises a first DC terminal and a second DC terminal, the second DC terminal being electrically isolated from the first DC terminal, wherein the first DC terminal comprises two planar electrical conductors and wherein the second DC terminal comprises one planar electrical conductor,
wherein the two planar electrical conductors of the first DC terminal and the one planar electrical conductor of the second DC terminal are planarly stacked with gaps between them, such that the one planar electrical conductor of the second DC terminal is sandwiched between the two planar electrical conductors of the first DC terminal.

2. The module for an electric circuit according to claim 1, wherein at least one of the two planar electrical conductors of the first DC terminal of the power package is provided with at least one recess adjacent to the substrate for allowing the one planar electrical conductor of the second DC terminal to connect to the electric circuitry via the at least one recess.

3. The module for an electric circuit according to claim 2, wherein the at least one recess of the at least one of the two planar electrical conductors of the first DC terminal of the power package comprises a plurality of recesses, wherein the plurality of recesses is distributed along a direction perpendicular to the stacking direction.

4. The module for an electric circuit according to any of the preceding claims, wherein the one planar electrical conductor of the second DC terminal of the power package is provided with at least one recess adjacent to the substrate, wherein said two planar electrical conductors of the first DC terminal connect to one another and to the electric circuitry via said at least one recess provided in the one planar electrical conductor of the second DC terminal.

5. The module for an electric circuit according to claim 4, wherein the at least one recess of the one planar electrical conductor of the second DC terminal of the power package comprises a plurality of recesses, wherein said plurality of recesses are distributed along a direction perpendicular to the stacking direction.

6. The module according to claim 3 in combination with claim 5, wherein said plurality of the recesses of the one planar electrical conductor of the second DC terminal is interleaved with said plurality of recesses of the at least one of the two planar electrical conductors of the first DC terminal.

7. The module according to any of the previous claims, wherein at least one of the two planar electrical conductors of the first DC terminal is provided with at least one protrusion along the substrate, wherein said at least one of the two planar electrical conductors of the first DC terminal connects to the electric circuitry via said at least one protrusion.

8. The module according to any of the previous claims, wherein the one planar electrical conductor of the second DC terminal is provided with at least one protrusion along the substrate, wherein said one planar electrical conductor of the second DC terminal connects to the electric circuitry via said at least one protrusion.

9. The module according to any of the previous claims, wherein the power package is provided with two side electrical conductors electrically connected to both planar electrical conductors of the first DC terminal, said side electrical conductors covering opposite sides of the one planar conductor of the second DC terminal, wherein said sides of the one planar conductor are perpendicular to the stacking direction.

10. The module according to claim 9, wherein all edges of the planar electrical conductors and all edges of said side electrical conductors are rounded.

11. The module according to any of the previous claims, wherein a material electrically isolating the planarly stacked DC terminals of the DC power package positioned in the gaps between of the planarly stacked electrical conductors is chosen from the list not limited to air, epoxy, resin, Mylar, Kapton, Nomex, or plastics such as ABS, PA, PC or PMMA.

12. The module according to any of the previous claims, wherein the first DC terminal comprises three planar electrical conductors, and the second DC terminal comprises two planar electrical conductors,
Wherein the three planar electrical conductors of the first DC terminal and the two planar electrical conductors of the second DC terminal are planarly stacked, such that a planar stack of alternating planar electrical conductors of the first and the second DC terminal, respectively, is provided.

13. The module according to any of the previous claims, wherein a distance between any of the planar conductors of the first and the second DC terminal, respectively, is at most 1.5mm.

14. A power module or a frame module comprising a module in accordance with any of the previous claims.

15. A method of fabricating a module in accordance with any of the previous claims, wherein said method comprises the steps of:
- providing said substrate
- mounting said DC power package to said substrate, such that said DC power package is electrically connected to the substrate.
